# EUROPÄISCHE PATENTSCHRIFT

(11) **EP 0 432 736 B1**
(45) Veröffentlichungstag und Bekanntmachung des Hinweises auf die Patenterteilung: **22.05.1996**
(21) Anmeldenummer: 90123838.6
(22) Anmeldetag: 11.12.1990
(51) Int. Cl.: H04N 5/50, H03J 7/18

(54) **Verfahren zur Programmspeicherung in Fernsehempfangsgeräten**
Programme storage method in television receivers
Procédé pour la mémorisation de programmes dans des récepteurs de télévision

(30) Priorität: 15.12.1989 DE 3941626
(43) Veröffentlichungstag der Anmeldung: 19.06.1991
(73) Patentinhaber: Bosch-Siemens Hausgeräte GmbH, D-81669 München (DE)
(72) Erfinder: Lerch, Dietmar, W-8060 Dachau (DE); Nickel, Rüdiger, W-8032 Gräfelfing/Lochham (DE)
(74) Vertreter: Rode, Franz

(56) Entgegenhaltungen:
- DE-A- 3 733 028
- FUNKSCHAU 1977, Heft 17, München WOLFGANG BAUM "Farbfernsehgerät mit Mikroprozessor-Steuerung" Seiten 763-768

## Beschreibung

Die Erfindung betrifft ein Verfahren und eine Anordnung zur Programmspeicherung in Fernsehempfangsgeräten, wobei eine Steuerung des Fernsehempfangsgerätes bei einem Sendersuchlauf über den von dem Fernsehempfangsgerät empfangbaren Fernsehsender-Frequenzbereich nacheinander Fernsehsenderfrequenzen detektiert, den Fernsehsenderfrequenzen entsprechende, vorzugsweise digitale Frequenzinformationen bildet und die gebildeten Frequenzinformationen in n Speicherplätze eines Speichers abspeichert, daß die Steuerung, ausgelöst durch Betätigung jeweils einer speicherplatzindividuellen Eingabetaste, die in dem zugehörigen Speicherplatz abgespeicherte Frequenzinformation abruft und das Fernsehempfangsgerät auf die der abgerufenen Frequenzinformation entsprechende Frequenz einstellt, wobei die Steuerung beim Sendersuchlauf neben den Fernsehsenderfrequenzen die ihnen zugeordneten Fernsehsender-Feldstärken detektiert, den Feldstärken entsprechende, vorzugsweise digitale Feldstärkeninformationen bildet und die gebildeten Frequenz- und Feldstärkeninformationen in 2n paarweise miteinander verknüpfte, nach ab- oder aufsteigenden Feldstärkewerten geordneten Speicherplätze abspeichert.

Im Empfangsbereich mehrerer Fernsehsender werden Signale dieser Sender entsprechend ihrer Sendeleistung und ihrer Entfernung zu einem bestimmten Empfangsort in der Regel mit unterschiedlichen Feldstärkewerten empfangen. Von diesen Werten hängt die Bild- und Tonqualität am Empfangsort ab. Fernsehzuschauer, die Programme unterschiedlicher Bild- und Tonqualitäten auswählen können, werden im Zweifel Programme guter Bild- und Tonqualität bevorzugen.

Aus der Zeitschrift "Funkschau" 1977, Heft 17, Seiten 763 - 768, ist ein Farbfernsehgerät mit Mikoroprozessor-Steuerung bekannt. Das bekannte Fernsehgerät ist mit einer Sender-Suchlauf-Automatik ausgestattet. Dabei ist eine sogenannte automatische Programmierung vorgesehen (Seite 765, mittlere Spalte), bei der bei einem Sendersuchlauf aufgefundene Senderdaten in der Reihenfolge ihres Auffindens in Speicherplätze eingespeichert werden. Im Anschluß daran können Senderdaten nach persönlichen Wünschen durch Tastenbetätigung miteinander in der Weise ausgetauscht werden, daß Senderdaten eines ersten Fernsehsenders in einen diesem Sender zugeordneten Speicherpaltz übertragen werden.

Die bekannte Fernsehgerätesteuerung speichert also lediglich die aufgefundenen Senderdaten in der Reihenfolge ihres Auffindens ab, wobei es einer Bedienperson überlassen bleibt, nach der Feststellung, welcher Taste welche Senderdaten zugeordnet sind, durch Betätigung von Tasten Senderdaten ausgewählter Fernsehsender bestimmte Speicherplätzen zuzuordnen.

Der Erfindung liegt demgegenüber die Aufgabe zugrunde, die Einstellung von Fernsehgeräten auf Fernsehsender unterschiedlicher Empfangsqualität bei einem Sendersuchlauf zu erleichtern.

Die Lösung dieser Aufgabe erfolgt erfindungsgemäß zum einen dadurch, daß die Steuerung im Anschluß an die Verteilung der gebildeten Frequenz- und Feldstärkeinformationspaare auf die Speicherplatzpaare, ausgelöst durch Betätigung einer Sondertaste und einer ersten speicherplatzindividuellen Taste, das in dem zugehörigen Speicherplatzpaar abgespeicherte Informationspaar in das Speicherplatzpaar überführt, in dem ursprünglich das der größten Feldstärke zugeordnete Informationspaar abgespeichert war, dieses Informationspaar sowie die übrigen Informationspaare auf die übrigen Speicherplatzpaare in abnehmender Reihenfolge der Feldstärkewerte verteilt.

Dieses erfindungsgemäße Verfahren hat für den Benutzer einerseits den Vorteil, daß er einzelne Tasten individuell belegen kann. Andererseits hat das Verfahren den Vorteil, daß der Benutzer davon entlastet wird, die übrigen Tasten ebenfalls manuell umzuprogrammieren. Vielmehr erfolgt die neue Belegung der übrigen Tasten durch die Steuerung des Fernsehempfangsgeräts, ohne daß es einer weiteren manuellen Schaltmaßnahme durch den Benutzer bedarf.

Die Lösung der Aufgabe erfolgt erfindungsgemäß zum anderen auch dadurch, daß die Steuerung im Anschluß an die Verteilung der gebildeten Frequenz- und Feldstärkeinformationspaare auf die Speicherplatzpaare, ausgelöst durch Betätigung einer Sondertaste, einer ersten speicherplatzindividuellen Eingabetaste und einer zweiten speicherplatzindividuellen Eingabetaste, die in den zugehörigen Speicherplatzpaaren abgespeicherten Informationspaare miteinander vertauscht.

Dieses erfindungsgemäße Verfahren hat für den Benutzer den Vorteil, daß er auch komplexere Tastenneubelegungen in einfacher Weise vornehmen kann.

Ein Anordnung zur Programmspeicherung in Fernsteuerungsgeräten zur Durchführung des erfindungsgemäßen Verfahrens ist dadurch gekennzeichnet, daß die Anordnung eine Fensehempfangsgeräte-Steuerung aufweist, die über einen Datenbus mit einem Speicher, der 2n paarweise miteinander verknüpfte Speicherplätze aufweist mit einem Betriebsprogramm-Speicher, in dem ein das Verfahren nach Anspruch 1 und/oder Anspruch 2 definierendes Steuerungsprogramm abgespeichert ist, und mit speicherplatzindividuellen Eingabetasten sowie zusätzlich mit einer Sondertaste verbunden ist.

Die erfindungsgemäße Steuerung verteilt die Frequenz- und Feldstärkeinformationen in der Weise auf die Speicherplätze, das in einem, einer ersten Eingabetaste zugeordneten Speicherplatzpaar das der größten Feldstärke entsprechende Informationspaar abgespeichert wird und daß in einem zweiten, einer zweiten Eingabetaste zugeordneten Speicherplatzpaar das der zweitgrößten Feldstärke entsprechende Informationspaar und in weiteren, den weiteren Eingabetasten zugeordneten Speicherplatzpaaren diejenigen Informationspaare abgespeichert werden, die den weiteren Feldstärken in abnehmender Reihenfolge ihrer Werte entsprechen.

Damit läßt sich durch Betätigung einer beispielsweise in einem Tastenfeld an einer besonderen Stelle angeordneten ersten Eingabetaste das Programm mit der besten empfangbaren Bild- und Tonqualität auswählen, ohne daß es erforderlich wäre, zuvor die den Tasten zugeordneten Fernsehprogramme (Senderfrequenzen) zu ermitteln. Auch entfällt die Notwendigkeit, die Zuordnung von Tasten bzw. Speicherplätzen und Senderfrequenzen manuell vorzunehmen.

Die Steuerung speichert nach der Bildung eines zeitlich ersten Frequenz- und Feldstärkeninformationspaars dieses in das dem größten Feldstärkewert zugeordneten Speicherplatzpaar ab. Nach der Bildung eines zeitlich zweiten Frequenz- und Feldstärkeninformationspaars vergleicht die Steuerung den entsprechenden zweiten Feldstärkewert mit dem dem zeitlich ersten Informationspaar entsprechenden ersten Feldstärkewert. Sofern der zweite Feldstärkewert gleich dem ersten Feldstärkewert oder kleiner als dieser ist, speichert die Steuerung das zweite Informationspaar in das dem zweitgrößten Feldstärkewert zugeordneten Speicherplatzpaar ab. Sofern jedoch der zweite Feldstärkewert größer als der erste Feldstärkewert ist, speichert sie das erste Informationspaar in das dem zweitgrößten Feldstärekwert zugeordneten Speicherplatzpaar und das zweite Informationspaar in das dem größten Feldstärkewert zugeordneten Speicherplatzpaar ab.

Nach Bildung jeweils eines zeitlich weiteren Informationspaars vergleicht die Steuerung den jeweils entsprechenden Feldstärkewert mit den den abgespeicherten Informationspaaren entsprechenden Feldstärkewerten und verteilt die abgespeicherten Informationspaare und das jeweils zeitlich weitere Informationspaar auf die den größten Feldstärkewerten zugeordneten Speicherplatzpaare, entsprechend der Zuorndung von Eingabetasten und Feldstärkewerten.

Bei dieser Ausführungsform wird für die Durchführung der Vergleichsopertionen vorteilhafterweise jeweils nur ein Zwischenspeicherplatzpaar benötigt.

Die Steuerung überführt im Anschluß an die Verteilung der gebildeten Frequenz- und Feldstärkeinformationspaare auf die Speicherplatzpaare, ausgelöst durch Betätigung einer Sondertaste und einer ersten speicherplatzindividuellen Taste das in dem zugehörigen Speicherplatzpaar abgespeicherte Informationspaar in das Speicherplatzpaar, in dem ursprünglich das der größten Feldstärke zugeordnete Informationspaar abgespeichert war, und verteilt dieses Informationspaar sowie die übrigen Informationspaare auf die übrigen Speicherplatzpaare in abnehmender Reihenfolge der Feldstärkewerte.

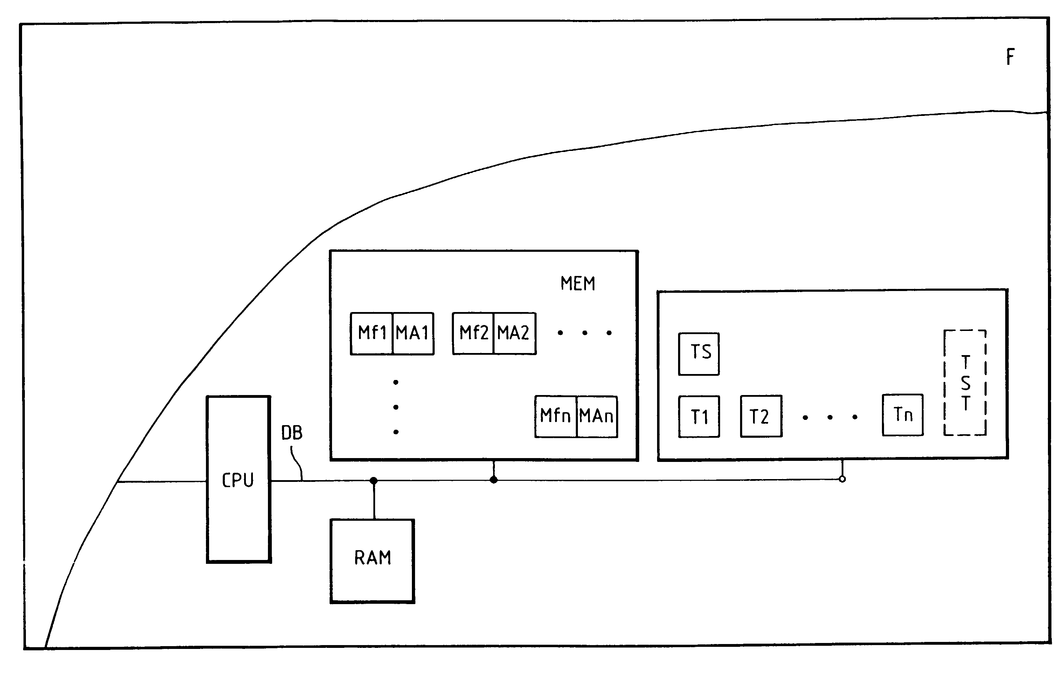

Die Erfindung wird nun anhand einer Figur beschrieben. Die Figur zeigt das Blockschaltbild einer Schaltung zur Steuerung einer Fernsehprogrammspeicherung. Ein Fernsehempfangsgerät F enthält eine Steuerung CPU, die über einen Datenbus DB mit einem Speicher MEM, einem Betriebsprogramm-Speicher RAM sowie mit Eingabetasten T1, T2, ...Tn und gegebenenfalls mit einer Sondertaste TS verbunden ist.

Der Speicher MEM weist vorzugsweise 2n paarweise miteinander verknüpfte Speicherplätze Mf1mA1, MF2MA2, ... MFnMAn auf. Die n Speicherplätze Mf1, Mf2, ... Mfn dienen der Aufnahme von Senderfrequenzinformationen f'1, f'2, ... f'n, während die n Speicherplätze MA1, MA2, ... MAn der Aufnahme von Feldstärkeinformationen A'1, A'2, ... A'n dienen.

Den Eingabetasten T1, T2, ... Tn sowie der Sondertaste TS kann eine mit der Steuerung CPU zusammenwirkende Steuerung TST zugeordnet sein. Die Tasten T1, ... Tn, TS können in einem Fernbedienungsgeber angeordnet sein und mit der Steuerung CPU drahtlos über in der Figur nicht dargestellte Sende- und Empfangseinrichtungen beziehungsweise über eine nicht dargestellte Verbindungsleitung verbunden sein.

Nicht dargestellt sind die für sich bekannten Einrichtungen des Fernsehempfangsgeräts zur Durchführung des Sendersuchlaufs, der Detektion von Fernsehsenderfrequenzen f1 ... fn, und Fernsehsenderfeldstärken A1 ... An sowie zur Bildung entsprechender Informationen f'1 ... f'n; A'1 ... A'n in vorzugsweise digitaler Darstellung.

Die prinzipielle Funktion der in der Figur dargestellten sowie der vorstehend genannten, nicht dargestellten Schaltungskomponente ist durch die eingangs genannte Sender-Suchllauf-Automatik bekannt.

Die erfindungsgemäßen Steuerungsoperationen, die durch das im Speicher RAM abgelegte Betriebsprogramm definiert sind, werden im folgenden beschrieben.

Ausgelöst durch ein Einschalten des Fernsehgeräts oder durch einen separaten Startbefehl initiiert die Steuerung CPU einen Sendersuchlauf und detektiert dabei mittels entsprechender Einrichtungen Fernsehsenderfrequenzen fx und die zugehörigen Feldstärkewerte Ax (X=1...n).

Sie veranlaßt die Bildung bzw. Codierung entsprechender Informationen f'x, A'x, in vorzugsweise digitaler Darstellung und speichert diese gebildeten Frequenz- und Feldstärkeinformationen jeweils eines Senders in ein Speicherplatzpaar MfxMAx des Speichers MEM ab. Jedem Speicherplatzpaar Mf1mA1 ... MfnMAn ist eine Eingabetgaste T1 ... Tn zugeordnet.

Nach Durchführung des Sendersuchlaufs und der Abspeicherung der gebildeten Frequenz- und Feldstärkeinformationspaare f'1A'1 ... f'nA'n in den Speicherplatzpaaren Mf1mA1 ... MfnMAn läßt sich durch Betätigung jeweils einer Eingabetaste T1 ... Tn das Fernsehgerät F auf die entsprechende Senderfrequenz f1 ... fn einstellen. Der Eingabetaste T1 ist die Senderfrequenz des Senders mit der höchsten Empfangsleistung zugeordnet, während den übrigen Eingabetasten T2 ... in die Senderfrequenzen der Sender mit abnehmender Empfangsleistung zugeordnet sind.

Die Verteilung der Frequenz- und Feldstärkeinformationen f'xA'x auf die Speicherplätze MfxMAx erfolgt dabei durch die Steuerung CPU in der Weise, daß in einem, einer ersten Eingabetaste T1 zugeordneten Speicherplatzpaar Mf1mA1 das der größten Feldstärke entsprechende Informationspaar f1A1 abgespeichert wird, und daß in einem zweiten, einer zweiten Eingabetaste T2 zugeordneten Speicherplatzpaar Mf2MA2 das der zweitgrößten Feldstärke entsprechende Informationspaar f'2A'2 und in weiteren, den weiteren Eingabetasten T3 ... Tn zugeordneten Speicherplatzpaaren Mf3MA3 ... MfnmAn diejenigen Informationspaare f'3A'3 ... f'nA'n abgespeichert werden, die den weiteren Feldstärken in abnehmender Reihenfolge ihrer Werte entsprechen.

Äquivalent hierzu ist eine Zuordnung der Informationspaare auf die Speicherplatzpaare in aufsteigender Reihenfolge der Feldstärkewerte.

Im einzelnen kann die Zuordnung der Frequenz- und Feldstärkeinformationspaare auf die Speicherplatzpaare in der folgenden Weise erfolgen:

Nach dem Start des Sendersuchlaufs und der Bildung eines zeitlich ersten Frequenz- und Feldstärkeinformationspaars speichert die Steuerung CPU dieses in das dem größten Feldstärkewert zugeordneten Speicherplatzpaar Mf1mA1 ab. Nach der Fortsetzung des Sendersuchlaufs und der Bildung eines zeitlich zweiten Frequenzund Feldstärkeinformationspaars vergleicht sie den entsprechenden zweiten Feldstärkewert mit dem dem zeitlich ersten Informationspaar entsprechenden ersten Feldstärkewert.

Das zeitlich zweite Informationspaar kann während des Vergleichs in einem separaten Zwischenspeicher oder in einem vor dem Vergleich nicht belegten Speicherplatz Mf2MA2 ... MfnmAn abgelegt sein.

Ergibt die Vergleichsoperation, daß der zeitlich zweite Feldstärkewert gleich dem zeitlich ersten Feldstärkewert oder kleiner als dieser ist, speichert die Steuerung CPU das zweite Informationspaar in das dem zweitgrößten Feldstärkewert zugeordenten Speicherplatzpaar Mf2MA2 ab. Ergibt der Vergleich dagegen, daß der zeitlich zweite Feldstärekwert größer als der zeitlich erste Feldstärkewert ist, speichert die Steuerung das erste Informationspaar in das dem zweitgrößten Feldstärkewert zugeordneten Speicherplatzpaar und das zweite Informationspaar in das dem größten Feldstärkewert zugeordneten Speicherplatzpaar ab.

Nach Fortsetzung des Sendersuchlaufs und der Bildung jeweils eines zeitlich weiteren Informationspaars vergleicht die Steuerung CPU den jeweils entsprechenden Feldstärkewert mit den den abgespeicherten Informationspaaren entsprechenden Feldstärkewerten und verteilt die abgespeicherten Informationspaare und das jeweils zeitlich weitere Informationspaar auf die den größten Feldstärkewerten zugeordneten Speicherplatzpaare entsprechend der Zuordnung von Eingabetasten und Feldstärkewerten.

Ebenso läßt sich der Eingabetaste T1 die Senderfrequenz des Senders mit der niedrigsten Empfangsleistung und den übrigen Eingabetasten T2 ... Tn die Senderfrequenzen der Sender mit zunehmendere Empfangsleistung zuordnen.

Erfindungsgemäß lassen sich noch weitere Zuordnungen realisieren, um die Einstellung ausgewählter Fernsehprogramme weiter zu erleichtern. Dabei wird eine oder mehrere Frequenzen bevorzugter Fernsehsender im Anschluß an die Durchführung der beschriebenen Steueroperationen einer bzw. mehrerer ausgewählten Eingabetasten zugeordnet.

Die Steuerung CPU überträgt hierzu im Anschluß an die Verteilung der gebildeten Frequenz- und Feldstärkeinformationspaare f'1A'1 ... f'nA'n auf die Speicherplatzpaare Mf1mA1 ... MfnMAn, ausgelöst durch Betätigung der Sondertaste TS und einer ersten speicherplatzindividuellen Taste Ti das in dem zugehörigen Speicherplatzpaar MfiMAi abgespeicherte Informationspaar f'iA'i in das Speicherplatzpaar Mf1mA1, in dem ursprünglich das der größten Feldstärke A1 zugeordnete Informationspaar f'1A'1 abgespeichert war, während dieses Informationspaar f'1A'1 sowie die übrigen Inforamtionspaare f'2A'2 ... f'i-1A'i-1, f'i+1A'i+1 ... f'nA'n auf die übrigen Speicherplatzpaare Mf2MA2 ... MfnMAn in abnehmender Reihenfolge der Feldstärkewerte verteilt werden.

Schließlich kann die Steuerung CPU im Anschluß an die Verteilung der gebildeten Frequenz- und Feldstärkeinformationspaare f'1A'1 ... f'nA'n auf die Speicherplatzpaare Mf1mA1 ... MfnMAn, ausgelöst durch Betätigung der Sondertaste TS, einer ersten speicherplatzindividuellen Eingabetaste Ti, beispielsweise T3, und einer zweiten speicherplatzindividuellen Eingabetaste Tj, beispielsweise T5, die in den zugehörigen Speicherplatzpaaren MfiMAi, MfjMAj abgespeicherten Informationspaare f'iA'i, f'jA'j miteinander vertauschen.

Ein Sendersuchlauf, der vorzugsweise durch einen separaten Schalter ausgelöst wird, und die dabei erfolgende Programmspeicherung ist grundsätzlich für jeden Empfangsort nur einmal durchzuführen, wobei die Speicher Mf1mA1 ... MfnMAn sowie auch der Speicher RAM als nichtflüchtiger Speicher ausgebildet sind. Ändern sich die Empfangsbedingungen jedoch beispielsweise dadurch, daß weitere Sendersignale empfangen werden können, ist ein erneuter Sendersuchlauf auszulösen, um auch die Informationspaare f'xA'x dieser Signale abzuspeichern.

## Patentansprüche

1. Verfahren zur Programmspeicherung in Fernsehempfangsgeräten, wobei eine Steuerung (CPU) des Fernsehempfangsgerätes (F) bei einem Sendersuchlauf über den von dem Fernsehempfangsgerät (F) empfangbaren Fernsehsender-Frequenzbereich nacheinander Fernsehsenderfrequenzen (fx, x =1...n) detektiert, den Fernsehsenderfrequenzen (fx) entsprechende, vorzugsweise digitale Frequenzinformationen (f'x, x = 1...n) bildet und die gebildeten Frequenzinformationen (f'x) in n Speicherplätze (Mfx, x =1...n) eines Speichers (MEM) abspeichert, daß die Steuerung (CPU), ausgelöst durch Betätigung jeweils einer speicherplatzindividuellen Eingabetaste (Tx, x = 1...n), die in dem zugehörigen Speicherplatz (Mfx, x = 1...n) abgespeicherte Frequenzinformation (f'x) abruft und das Fernsehempfangsgerät auf die der abgerufenen Frequenzinformation (f'x) entsprechende Frequenz (fx) einstellt, wobei die Steuerung (CPU) beim Sendersuchlauf neben den Fernsehsenderfrequenzen (fx, x = 1...n) die ihnen zugeordneten Fernsehsender-Feldstärken (Ax, x = 1...n) detektiert, den Feldstärken (Ax, x = 1...n) entsprechende, vorzugsweise digitale Feldstärkeninformationen (A'x, x =1...n) bildet und die gebildeten Frequenz- und Feldstärkeninformationen (f'x, Ax, x = 1...n) in 2n paarweise miteinander verknüpfte, nach aboder aufsteigenden Feldstärkewerten geordneten Speicherplätze (MfxMAx, x =1...n) abspeichert, **dadurch gekennzeichnet**, daß die Steuerung (CPU) im Anschluß an die Verteilung der gebildeten Frequenz- und Feldstärkeinformationspaare (f'1A'1 ... f'nA'n) auf die Speicherplatzpaare (Mf1mA1 ... MfnMAn), ausgelöst durch Betätigung einer Sondertaste (TS) und einer ersten speicherplatzindividuellen Taste (Ti), das in dem zugehörigen Speicherplatzpaar (MfiMAi) abgespeicherte Informationspaar (f'iA'i) in das Speicherplatzpaar (Mf1mA1) überführt, in dem ursprünglich das der größten Feldstärke (A1) zugeordnete Informationspaar (f'1A'1) abgespeichert war, dieses Informationspaar (f'1A'1) sowie die übrigen Informationspaare (f'2A '2 ... f'i-1. f'i+1 ... f'nA'n) auf die übrigen Speicherplatzpaare (Mf2MA2 ... MfnMAn) in abnehmender Reihenfolge der Feldstärkewerte verteilt.

2. Verfahren zur Programmspeicherung in Fernsehempfangsgeräten, wobei eine Steuerung (CPU) des Fernsehempfangsgerätes (F) bei einem Sendersuchlauf über den von dem Fernsehempfangsgerät (F) empfangbaren Fernsehsender-Frequenzbereich nacheinander Fernsehsenderfrequenzen (fx, x =1...n) detektiert, den Fernsehsenderfrequenzen (fx) entsprechende, vorzugsweise digitale Frequenzinformationen (f'x, x = 1...n) bildet und die gebildeten Frequenzinformationen (f'x) in n Speicherplätze (Mfx, x =1...n) eines Speichers (MEM) abspeichert, daß die Steuerung (CPU), ausgelöst durch Betätigung jeweils einer speicherplatzindividuellen Eingabetaste (Tx, x = 1...n), die in dem zugehörigen Speicherplatz (Mfx, x = 1...n) abgespeicherte Frequenzinformation (f'x) abruft und das Fernsehempfangsgerät auf die der abgerufenen Frequenzinformation (f'x) entsprechende Frequenz (fx) einstellt, wobei die Steuerung (CPU) beim Sendersuchlauf neben den Fernsehsenderfrequenzen (fx, x = 1...n) die ihnen zugeordneten Fernsehsender-Feldstärken (Ax, x = 1...n) detektiert, den Feldstärken (Ax, x = 1...n) entsprechende, vorzugsweise digitale Feldstärkeninformationen (A'x, x =1...n) bildet und die gebildeten Frequenz- und Feldstärkeninformationen (f'x, Ax, x = 1...n) in 2n paarweise miteinander verknüpfte, nach aboder aufsteigenden Feldstärkewerten geordneten Speicherplätze (MfxMAx, x = 1...n) abspeichert, **dadurch gekennzeichnet**, daß die Steuerung (CPU) im Anschluß an die Verteilung der gebildeten Frequenz- und Feldstärkeinformationspaare (f'1A'1 ... f'1A'n) auf die Speicherplatzpaare (Mf1mA1 ... MfnMAn), ausgelöst durch Betätigung einer Sondertaste (TS), einer ersten speicherplatzindividuellen Eingabetaste (Ti) und einer zweiten speicherplatzindividuellen Eingabetaste (Tj), die in den zugehörigen Speicherplatzpaaren (MfiMAi, MfjMAj) abgespeicherten Informationspaare (f'iA'i, f'jA'j) miteinander vertauscht.

3. Anordnung zur Programmspeicherung in Fernsehempfangsgeräten, wobei eine Steuerung (CPU) des Fernsehempfangsgerätes (F) bei einem Sendersuchlauf über den von dem Fernsehempfangsgerät (F) empfangbaren Fernsehsender-Frequenzbereich nacheinander Fernsehsenderfrequenzen (fx, x =1...n) detektiert, den Fernsehsenderfrequenzen (fx) entsprechende, vorzugsweise digitale Frequenzinformationen (f'x, x = 1...n) bildet und die gebildeten Frequenzinformationen (f'x) in n Speicherplätze (Mfx, x =1...n) eines Speichers (MEM) abspeichert, daß die Steuerung (CPU), ausgelöst durch Betätigung jeweils einer speicherplatzindividuellen Eingabetaste (Tx, x = 1...n), die in dem zugehörigen Speicherplatz (Mfx, x = 1...n) abgespeicherte Frequenzinformation (f'x) abruft und das Fernsehempfangsgerät auf die der abgerufenen Frequenzinformation (f'x) entsprechende Frequenz (fx) einstellt, wobei die Steuerung (CPU) beim Sendersuchlauf neben den Fernsehsenderfrequenzen (fx, x = 1...n) die ihnen zugeordneten Fernsehsender-Feldstärken (Ax, x = 1...n) detektiert, den Feldstärken (Ax, x = 1...n) entsprechende, vorzugsweise digitale Feldstärkeninformationen (A'x, x = 1...n) bildet und die gebildeten Frequenz- und Feldstärkeninformationen (f'x, Ax, x = 1...n) in 2n paarweise miteinander verknüpfte, nach aboder aufsteigenden Feldstärkewerten geordneten Speicherplätze (MfxMAx, x = 1...n) abspeichert, **dadurch gekennzeichnet**, daß die Anordnung eine Fensehempfangsgeräte-Steuerung (CPU) aufweist, die über einen Datenbus (DB) mit einem Speicher (MEM), der 2n paarweise miteinander verknüpfte Speicherplätze (Mf1mA1, Mf2MA2, ... MFnMAn) aufweist mit einem Betriebsprogramm-Speicher (RAM), in dem ein das Verfahren nach Anspruch 1 und/oder Anspruch 2 definierendes Steuerungsprogramm abgespeichert ist, und mit speicherplatzindividuellen Eingabetasten (t1, T2, ... Tn) sowie zusätzlich mit einer Sondertaste (TS) verbunden ist.

4. Anordnung nach Anspruch 3, dadurch gekennzeichnet, daß die Eingabetasten (T1, T2, ...Tn) und die Sondertaste (TS) in einem Fernbedienungsgeber angeordnet sind, der mit der Steuerung (CPU) drahtlos oder mittels einer Verbindungsleitung verbindbar ist.

5. Anordnung nach einem der Ansprüche 3 oder 4, dadurch gekennzeichnet, daß die Speicher (RAM, Mf1mA1 ... MfnMAn) als nichtflüchtige Speicher ausgebildet sind.

## Claims

1. Method of program controlling in a television receiver apparatus, wherein a control device (CPU) of the television receiver apparatus (F) during a transmission search operation detects successive television transmission frequencies (Fx, x = 1...n) by way of the television transmission frequency range receivable by the television receiver apparatus (F), forms frequency data (f'x, x = 1...n) which correspond to the television transmission frequencies (fx) and are preferably digital and stores the formed frequency data (f'x) in n storage places (Mfx, x = n...1) of a storage device (MEM), that the control device (CPU), triggered by actuation each time of an input key (Tx, x = 1...n) individual to storage place, calls up the item of frequency data (f'x) stored in the associated storage place (Mfx, x = 1...n) and sets the television receiver apparatus to the frequency (fx) corresponding to the called-up item of frequency data (f'x), wherein the control device (CPU) during the transmission search operation detects, apart from the television transmission frequencies (fx, x = n...1), the television transmission field strengths (Ax, x = 1...n) associated therewith, forms field strength data (A'x, x = n...1) which correspond to the field strengths (Ax, x = 1...n) and are preferably digital, and stores the formed frequency and field strength data (f'x, Ax, x = 1...n) in storage places (MfxMAx, x = 1...n) which are interlinked in 2n pairs and ordered according to descending or ascending field strength values, characterised thereby that the control device (CPU) subsequently to the distribution of the formed frequency and field strength data pairs (f'1A'1 ... f'nA'n) to the storage place pairs (Mf1MA1 ... MfnMAn) and triggered by actuation of a separate key (TS) and a first key (Ti) individual to storage place transfers the data pair (f'iA'i) stored in the associated storage place pair (MfiMAi) into the storage place pair (Mf1MA1) in which originally the data pair (f'1A'1) associated with the greatest field strength (A1) was stored and distributes this data pair (f'1A') as well as the remaining data pairs (f'2A'2 ... f'i-1, f'i+1 ... f'nA'n) to the remaining storage place pairs (Mf2MA2 ... MfnMAn) in decreasing sequence of the field strength values.

2. Method of program controlling in a television receiver apparatus, wherein a control device (CPU) of the television receiver apparatus (F) during a transmission search operation detects successive television transmission frequencies (Fx, x = 1...n) by way of the television transmission frequency range receivable by the television receiver apparatus (F), forms frequency data (f'x, x = 1...n) which correspond to the television transmission frequencies (fx) and are preferably digital and stores the formed frequency data (f'x) in n storage places (Mfx, x = n...1) of a storage device (MEM), that the control device (CPU), triggered by actuation each time of an input key (Tx, x = 1...n) individual to storage place, calls up the item of frequency data (f'x) stored in the associated storage place (Mfx, x = 1...n) and sets the television receiver apparatus to the frequency (fx) corresponding to the called-up item of frequency data (f'x), wherein the control device (CPU) during the transmission search operation detects, apart from the television transmission frequencies (fx, x = n...1), the television transmission field strengths (Ax, x = 1...n) associated therewith, forms field strength data (A'x, x = n...1) which correspond to the field strengths (Ax, x = 1...n) and are preferably digital, and stores the formed frequency and field strength data (f'x, Ax, x = 1...n) in storage places (MfxMAx, x = 1...n) which are interlinked in 2n pairs and ordered according to descending or ascending field strength values, characterised thereby that the control device (CPU) subsequently to the distribution of the formed frequency and field strength data pairs (f'1A'1 ... f'nA'n) to the storage place pairs (Mf1MA1 ... MfnMAn) and triggered by actuation of a separate key (TS), a first input key (Ti) individual to storage place and a second input key (Tj) individual to storage place interchanges the data pairs (f'iA'i, f'jA'j) stored in the associated storage place pairs (MfiMAi, MfjMAj).

3. Arrangement for program storage in television receiver apparatus, wherein a control device (CPU) of the television receiver apparatus (F) during a transmission search operation detects successive television transmission frequencies (fx, x = 1...n) by way of the television transmission frequency range receivable by the television receiver apparatus (F), forms frequency data (f'x, x = 1...n) which correspond to the television transmission frequencies (fx) and are preferably digital and stores the formed frequency data (f'x) in n storage places (Mfx, x = n...1) of a storage device (MEM), that the control device (CPU), triggered by actuation each time of an input key (Tx, x = 1...n) individual to storage place, calls up the item of frequency data (f'x) stored in the associated storage place (Mfx, x = 1...n) and sets the television receiver apparatus to the frequency (fx) corresponding to the called-up item of frequency data (f'x), wherein the control device (CPU) during the transmission search operation detects, apart from the television transmission frequencies (fx, x = n...1), the television transmission field strengths (Ax, x = 1...n) associated therewith, forms field strength data (A'x, x = n...1) which correspond to the field strengths (Ax, x = 1...n) and are preferably digital, and stores the formed frequency and field strength data (f'x, Ax, x = 1...n) in storage places (MfxMAx, x = 1...n) which are interlinked in 2n pairs and ordered according to descending or ascending field strength values, characterised thereby that the arrangement comprises a television receiver control device (CPU) which is connected by way of a data bus (DB) with a store (MEM), which comprises storage places (Mf1MA1, Mf2MA2, ... MFnMAn) interlinked in 2n pairs, with an operating program store (RAM) in which a control program defining the method according to claim 1 and/or claim 2 is stored, and is connected with input keys (t1, T2, ... Tn) individual to storage place as well as additionally with a separate key (TS).

4. Arrangement according to claim 3, characterised thereby that the input keys (T1, T2 ...Tn) and the separate key (TS) are arranged in a remote control transmitter which is connected with the control device (CPU) wirelessly or by means of a connecting line.

5. Arrangement according to one of claims 3 or 4, characterised thereby that the stores (RAM, Mf1MA1 ... MfnMAn) are constructed as non-volatile storage devices.

## Revendications

1. Procédé de mémorisation de programmes dans des récepteurs de télévision, dans lequel une commande (CPU) du récepteur de télévision (F), lors d'une recherche de station, détecte successivement les fréquences (fx, x=1...n) des émetteurs de télévision dans la plage de fréquences des émetteurs pouvant être reçue par le récepteur de télévision (F), forme des informations (f'x, x=1...n) de fréquence, de préférence numériques, qui correspondent aux fréquences (fx) des émetteurs de télévision et mémorise les informations de fréquence (f'x) dans n emplacements de mémoire (Mfx, x=1...n) d'une mémoire (MEM), la commande (CPU), activée chaque fois par l'actionnement d'une touche d'entrée (Tx, x=1...n) associée à chaque emplacement de mémoire, appelle l'information de fréquence (f'x) stockée dans l'emplacement de mémoire (Mfx, x=1...n) concerné et règle le récepteur de télévision sur la fréquence (fx) qui correspond à l'information de fréquence (f'x) appelée, la commande (CPU), lors de la recherche, détecte, outre les fréquences (fx, x=1...n) des émetteurs de télévision, les intensités de champ (Ax, x=1...n) associées des émetteurs de télévision, forme des informations d'intensité de champ (A'x, x=1...n) de préférence numériques et mémorise par intensités de champ décroissantes ou croissantes les informations de fréquence et de champ (f'x, A'x x=1...n) ainsi formées dans 2n emplacements de mémoire (MfxMax, x=1...n) qui sont liés par paires les uns aux autres, caractérisé par le fait que, consécutivement à la répartition des couples d'informations de fréquence et d'intensité de champ (f'1A'1...f'nA'n) dans les couples d'emplacements de mémoire (Mf1mA1...MfnmAn), la commande (CPU), activée par l'actionnement d'une touche (TS) spéciale et d'une première touche (Ti) associée à un emplacement de mémoire, transfert le couple d'informations (f'1A'i) stocké dans l'emplacement de mémoire (MfiMAi) dans l'emplacement de mémoire (Mf1mA1) où était stocké à l'origine le couple d'informations (f'1A'1) associé à la plus forte intensité de champ et distribue ce couple d'informations (f'1A'1) ainsi que les autres couples d'informations (f'2A'2...f'i-1, f'i+1. . ,f'1 nA'n) par intensités de champ décroissantes dans les autres emplacements de mémoire (Mf2MA2...MfnMAn).

2. Procédé de mémorisation de programmes dans des récepteurs de télévision, dans lequel une commande (CPU) du récepteur de télévision (F), lors d'une recherche de station, détecte successivement les fréquences (fx, x=1...n) des émetteurs de télévision dans la plage de fréquences des émetteurs pouvant être reçue par le récepteur de télévision (F), forme des informations (f'x, x=1...n) de fréquence, de préférence numériques, qui correspondent aux fréquences (fx) des émetteurs de télévision et mémorise les informations de fréquence (fx) dans n emplacements de mémoire (Mfx, x=1...n) d'une mémoire (MEM), la commande (CPU), activée chaque fois par l'actionnement d'une touche d'entrée (Tx, x=1...n) associée à chaque emplacement de mémoire, appelle l'information de fréquence (f'x) stockée dans l'emplacement de mémoire (Mfx, x=1...n) concerné et règle le récepteur de télévision sur la fréquence (fx) qui correspond à l'information de fréquence (f'x) appelée, la commande (CPU), lors de la recherche, détecte, outre les fréquences (fx, x=1...n) des émetteurs de télévision, les intensités de champ (Ax, x=1...n) associées des émetteurs de télévision, forme des informations d'intensité de champ (A'x, x=1...n) de préférence numériques et mémorise par intensités de champ décroissantes ou croissantes les informations de fréquence et de champ (f'x, A'x x=1...n) ainsi formées dans 2n emplacements de mémoire (MfxMax, x=1...n) qui sont liés par paires les uns aux autres, caractérisé par le fait que consécutivement à la répartition des couples d'informations de fréquence et d'intensité de champ (f'1A'1..,f'nA'n) dans les couples d'emplacements de mémoire (Mf1MA1...MfnMAn), la commande (CPU), activée par l'actionnement d'une touche (TS) spéciale, d'une première touche (Ti) associée à un emplacement de mémoire et d'une seconde touche (Tj) associée à un emplacement de mémoire, intervertit les couples d'informations (f'iA'i, fjA'j) stockés dans les emplacements de mémoire (MfiMAi, MfjMAj) correspondants.

3. Dispositif de mémorisation de programmes dans des récepteurs de télévision, dans lequel une commande (CPU) du récepteur de télévision (F), lors d'une recherche de station, détecte successivement les fréquences (fx, x=1...n) des émetteurs de télévision dans la plage de fréquences des émetteurs pouvant être reçue par le récepteur de télévision (F), forme des informations (fx, x=1...n) de fréquence, de préférence numériques, qui correspondent aux fréquences (fx) des émetteurs de télévision et mémorise les informations de fréquence (f'x) ainsi formées dans n emplacements de mémoire (Mfx, x=1...n) d'une mémoire (MEM), la commande (CPU), activée chaque fois par l'actionnement d'une touche d'entrée (Tx, x=1...n) associée à chaque emplacement de mémoire, appelle l'information de fréquence (f'x) stockée dans l'emplacement de mémoire (Mfx, x=1...n) correspondant et règle le récepteur de télévision sur la fréquence (fx) qui correspond à l'information de fréquence (f'x) appelée, la commande (CPU), lors de la recherche, détecte, outre les fréquences (fx, x=1...n) des émetteurs de télévision, les intensités de champ (Ax, x=1...n) associées des émetteurs de télévision, forme des informations d'intensité de champ (A'x, x=1...n), de préférence numériques, et mémorise par intensités de champ décroissantes ou croissantes les informations de fréquence et de champ (f'x, A'x x=1...n) ainsi formées dans 2n emplacements de mémoire (MfxMax, x=1...n) qui sont liés par paires les uns aux autres, caractérisé par le fait que le dispositif comprend une commande (CPU) de récepteur de télévision qui est reliée par l'intermédiaire d'un bus de données (DB) à une mémoire (MEM) avec 2n emplacements de mémoire (Mf1MA1, Mf2MA2...MfnMAn), avec une mémoire de programme (RAM) dans laquelle est stocké un programme décrivant le procédé selon la revendication 1 et/ou la revendication 2 et avec des touches d'entrée (T1, T2...Tn) individuelles pour chaque emplacement de mémoire ainsi qu'une touche spéciale (TS) supplémentaire.

4. Dispositif selon la revendication 3, caractérisé par le fait que les touches d'entrée (T1, T2...Tn) et la touche spéciale (TS) sont disposées dans une commande à distance qui peut communiquer sans fil ou par l'intermédiaire d'un câble de liaison avec la commande (CPU).

5. Dispositif selon la revendication 3 ou la revendication 4, caractérisé par le fait que les mémoires (RAM, Mf1MA1...MfnmAn) sont réalisées sous forme de mémoires non volatiles.
